# EUROPEAN PATENT APPLICATION

(11) **EP 1 833 087 A1**
(43) Date of publication of application: **12.09.2007**
(21) Application number: 05720595.7
(22) Date of filing: 11.03.2005
(51) Int. Cl.: H01L 21/8234, H01L 21/28, H01L 27/088, H01L 29/417

(54) **SEMICONDUCTOR DEVICE AND METHOD FOR MANUFACTURING SAME**

(30) Priority: 28.12.2004 JP 2004379620
(71) Applicant: MATSUSHITA ELECTRIC INDUSTRIAL CO., LTD., Osaka 571-8501 (JP)
(72) Inventor: OHTA, Sougo c/o Matsushita El. Ind. Co, Ltd, Chuo-ku, Osaka-shi, Osaka 540-6319 (JP)
(74) Representative: Grünecker, Kinkeldey, Stockmair & Schwanhäusser Anwaltssozietät
(86) International application number: PCT/JP2005/004324
(87) International publication number: WO 2006/070490

(57) **Abstract**

A thickness of each of side walls (105) in a transistor TrA is made thinner than a thickness of each of side walls (105) in a transistor TrB. In the transistor TrA, a surface of a high concentration impurity diffusion layer (106) and a bottom portion of the side wall (105) are at overlapping positions when viewed from a principal surface direction of a substrate. A silicide layer (108) is formed only in the high concentration impurity diffusion layer (106). Such limited formation can be realized by forming the high concentration impurity diffusion layer (106) in the transistor TrA after forming a CVD oxide film (111) covering the transistor TrB and prior to forming the silicide layer (108). In such a manner, off-leak characteristics can be improved by a simple structure, and the silicide transistor and the non-silicide transistor can be concurrently formed on the same one substrate.

## Description

### TECHNICAL FIELD

The present invention relates to a semiconductor device and a method for manufacturing the same. More particularly, the present invention relates to a semiconductor device which includes transistors having silicide layers and a method for manufacturing the same.

### BACKGROUND ART

In a semiconductor device including a MOS transistor or the like, a silicide layer made of refractory metal silicide is used for wires which attain high heat-resisting properties and low resistance. As a technique for forming such a silicide layer, there is a salicide technique in which a refractory metal silicide (hereinafter, referred to as silicide) is formed by reacting a silicon material, with a diffusion layer formed in a silicon substrate, a gate electrode made of polycrystalline silicon, with a refractory metal such as titanium (Ti) and cobalt (Co), and a silicide layer is left remaining in a self-aligning manner by selectively removing an unreacted refractory metal through etching processing.

For example, proposed in patent document 1 is a semiconductor device which comprises a MOS transistor (hereinafter, referred to as a silicide transistor) having the silicide layer formed by the silicide technique and a MOS transistor (hereinafter, referred to as a non-silicide transistor) having no silicide layer formed on the same one substrate. When manufacturing this semiconductor device, by employing the salicide technique, the silicide transistor and the non-silicide transistor can be concurrently formed on a semiconductor substrate. In the semiconductor device having the silicide transistor, if a high voltage, caused by noise or the like, is externally applied in an abrupt manner to the transistor, the transistor may be easily damaged because the silicide layer is formed therein, generating a leakage current. Therefore, in recent years, as disclosed in patent document 1, the semiconductor device having the silicide transistor and the non-silicide transistor on the same one substrate has come into widespread use.

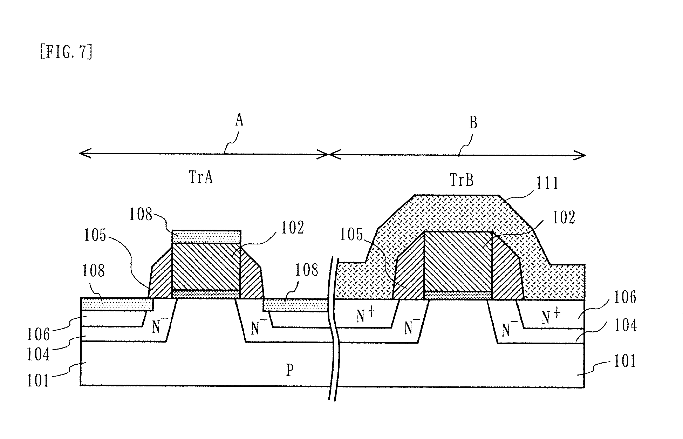

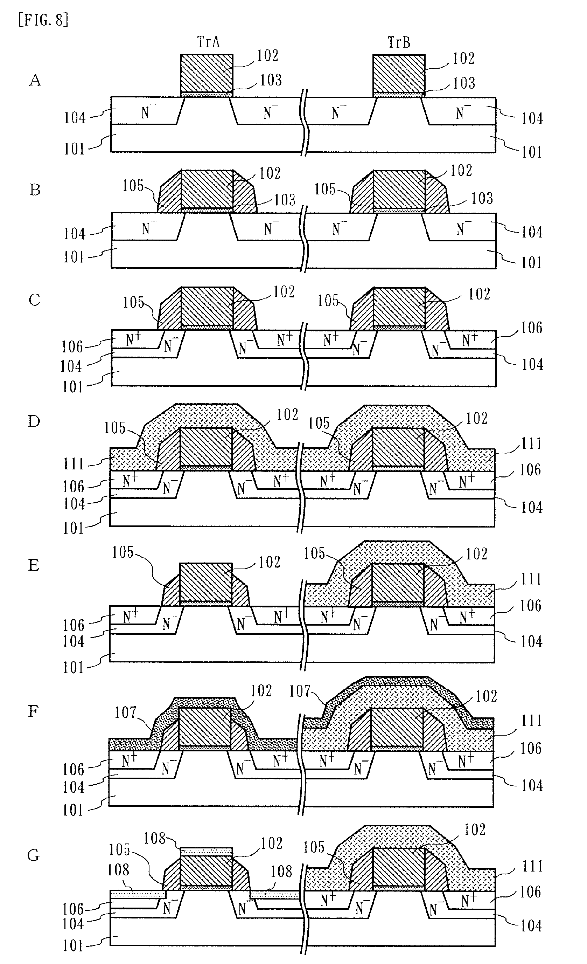

FIG. 7 is a diagram illustrating a sectional view of a structure of a semiconductor device having a silicide transistor and a non-silicide transistor on the same one substrate. In FIG. 7, on the semiconductor substrate 101, a silicide MOS transistor TrA and a non-silicide MOS transistor TrB are formed. In the silicide MOS transistor TrA, a silicide layer 108 is formed on a surface of a diffusion layer serving as a source diffusion layer and as a drain diffusion layer and on a surface of a gate electrode 102. A surface of the MOS transistor TrB is covered by a CVD oxide film 111, thereby preventing formation of a silicide layer. When manufacturing the semiconductor device having the above-mentioned structure, by employing a method in which respective processes shown in FIG. 8 are performed, the silicide MOS transistor TrA and the non-silicide MOS transistor TrB can be concurrently formed on the semiconductor substrate 101. Hereinunder, descriptions will be given by referring to a region including a silicide layer as a silicide region A and to a region including no silicide layer as a non-silicide region B.

FIG. 8 is a diagram illustrating sectional views of the substrate and a portion thereon in processes of manufacturing the semiconductor device shown in FIG. 7. In order to obtain a semiconductor device in an in-process state, shown in FIG. 8A, a gate oxide film 103 and a polysilicon film for forming the silicide MOS transistor TrA and the non-silicide MOS transistor TrB are first deposited on a principal surface of the semiconductor substrate 101. Next, by pattern-forming the gate oxide film 103 and the polysilicon film, the gate electrode 102 is formed on the gate oxide film 103. Using the obtained gate electrode 102 as a mask, an N-type impurity is introduced on the principal surface of the semiconductor substrate 101 so as not to apply a high electric field to a channel region under the gate electrode 102. Thus, an N-type (hereinafter, written as N⁻ type) diffusion layer, of which impurity concentration is low, serving as the source diffusion layer and the drain diffusion layer is formed. Hereinafter, the N⁻ type diffusion layer is referred to as an LDD layer 104.

FIG. 8B is a diagram illustrating a state where side walls 105 are formed on lateral walls of the gate electrode 102 for forming each of the silicide MOS transistor TrA and the non-silicide MOS transistor TrB. The side walls 105 are formed in the following procedure. First, a CVD oxide film (not shown) is deposited on an entire surface of the semiconductor substrate 101 in a state shown in FIG. 8A. Next, the CVD oxide film is etched back through reactive ion etching until the surface of the semiconductor substrate 101 is exposed. Thus, the side walls 105 are formed on the lateral walls of the gate electrode 102 in a self-aligning manner.

FIG. 8C is a diagram illustrating a state where an N type (hereinafter, written as N⁺ type) high concentration impurity diffusion layer 106, of which impurity concentration is higher than that of the LDD layer 104, is formed inside of the LDD layer 104 for forming the silicide MOS transistor TrA and the non-silicide MOS transistor TrB. The high concentration impurity diffusion layer 106 is formed by high concentration ion implanting in the LDD layer 104 through employing a self-aligning method in which the side walls 105 are utilized.

FIG. 8D is a diagram illustrating a state where the CVD oxide film 111 is formed on the principal surface of the semiconductor substrate 101. The CVD oxide film 111 is formed so as to cover the entire surface of the semiconductor substrate 101 through employing a CVD method. The CVD oxide film 111 is, as mentioned below, utilized for selectively forming the silicide region A and the non-silicide region B.

FIG. 8E is a diagram illustrating a state where the CVD oxide film 111 is selectively etching-processed. In order to obtain the CVD oxide film 111 in this state, only the CVD oxide film 111 covering the silicide region A is subjected to wet etching processing using hydrofluoric acid (HF) and the like. Thus, only the CVD oxide film 111 covering the silicide regionA is selectively removed and the CVD oxide film 111 covering the non-silicide region B remains as masking for the non-silicide region B. Through the wet etching processing, a film thickness of the side wall 105 of the silicide MOS transistor TrA is decreased by an over-etched film thickness.

FIG. 8F is a diagram illustrating a state where a refractory metal film 107 is formed on the entire surface of the semiconductor substrate 101. The refractory metal film 107 is obtained by a sputtering deposition of a refractory metal such as titanium (Ti) and cobalt (Co) on the entire surface of the semiconductor substrate 101.

FIG. 8G is a diagram illustrating a state of the semiconductor device having formed therein the silicide MOS transistor TrA and the non-silicide MOS transistor TrB. In order to obtain the semiconductor substrate 101 having formed thereon such an integrated circuit, the refractory metal film 107 formed in the process shown above in FIG. 8F is first subjected to first heat treatment. Thus, the silicide is formed on a portion where a silicon material contacts the refractory metal film 107 and the refractory metal film 107 remains unreacted on a portion other than the portion where the silicon material contacts the refractory metal film 107. Next, the refractory metal film 107 which has been unreacted through the first heat treatment is removed through the wet etching and thereafter, second heat treatment is performed. Thus, in the silicide MOS transistor TrA, the silicide layer 108 is formed in a self-aligning manner only on surfaces of the source diffusion layer and the drain diffusion layer and on a surface of the gate electrode 102. On the same one substrate, the silicide MOS transistor TrA and the non-silicide MOS transistor TrB are concurrently formed.

On the semiconductor substrate 101 on which the silicide region A and the non-silicide region B have been formed through undergoing the above-mentioned processes, an interlayer dielectric, wires, and the like are formed through employing conventionally known methods, resulting in the semiconductor device.
[Patent document 1] Japanese Laid-Open Patent Publication No. 2002-164355

### DISCLOSURE OF THE INVENTION

### PROBLEMS TO BE SOLVED BY THE INVENTION

However, when manufacturing the semiconductor device in the above-mentioned processes, the film thickness of the side wall 105 of the silicide MOS transistor TrA is decreased by the over-etched film thickness in the process shown in FIG. 8E in which the CVD oxide film 111 is subjected to the wet etching. Specifically, before and in the process shown in FIG. 8D, a bottom portion of the side wall 105 is, when viewed from a direction of the principal surface of the substrate, at a position of overlapping a surface of the high concentration impurity diffusion layer 106. By contrast, after the wet etching, as shown in FIG. 8E, the bottom portion of the side wall 105 is, when viewed from the direction of the principal surface of the substrate, at a position of not overlapping the surface of the high concentration impurity diffusion layer 106 due to the decrease in the film thickness. Accordingly, the refractory metal film 107 formed in the process shown in FIG. 8F contacts an entire surface of the high concentration impurity diffusion layer 106. Therefore, the silicide layer 108 formed in the process shown in FIG. 8G is formed on the entire surface of the high concentration impurity diffusion layer 106, and an edge portion thereof stretches to the LDD layer 104 due to thermal diffusion.

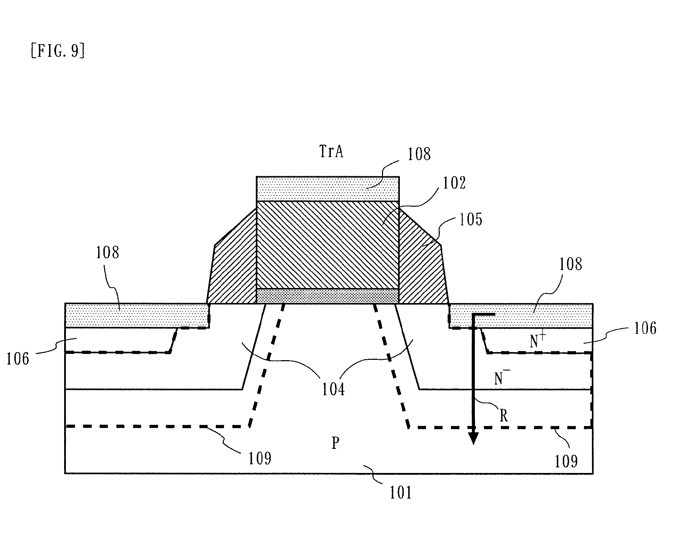

The semiconductor device in which the silicide layer 108 is formed so as to protrude over the high concentration impurity diffusion layer 106 and to reach the LDD layer 104 has a problem that off-leak characteristics of the transistor may be easily degraded. The reason for this will be described below. FIG. 9 is a schematic diagram illustrating a state where in the semiconductor device shown in FIG. 7, an electric field is applied to the drain diffusion layer of the silicide MOS transistor TrA. In FIG. 9, when the electric field is applied to the drain diffusion layer, a depletion layer 109 is formed at an interface between the P type semiconductor substrate 101 and N⁻ type LDD layer 104. The depletion layer 109, depending on conditions of the applied electric field, stretches to not only a side of the semiconductor substrate 101 but also a side of the LDD layer 104. The depletion layer 109 resulting thereupon is characterized in that the depletion layer 109 is easily stretchable inside of the LDD layer 104 having a low impurity concentration whereas the depletion layer 109 is not easily stretchable inside of the high concentration impurity diffusion layer 106 having a high impurity concentration. Therefore, the depletion layer 109 stretching toward the side of the LDD layer 104 stops stretching at the interface between the LDD layer 104 and the high concentration impurity diffusion layer 106.

When the above-mentioned depletion layer 109 is formed, in the semiconductor device shown in FIG. 9, since the silicide layer 108 protrudes to the inside of the LDD layer 104, the depletion layer 109 and the silicide layer 108 contact each other inside of the LDD layer 104. When the depletion layer 109 and the silicide layer 108 contact each other, as indicated by an arrow R in FIG. 9, a leak pass is generated from the silicide layer 108 toward a direction of the semiconductor substrate 101 and a leakage current of approximately 1 pA/µm easily flows, thereby resulting in a problem of deterioration in the off-leak characteristics of the transistor.

The above-mentioned phenomenon is notable in a transistor or the like which is formed by using the recent high density fine-dimensional element pattern. For example, in an N channel MOS transistor which is manufactured by employing a process technique with 0.25 *µ* m or less, with a power voltage being approximately 2.5V to 5V, a horizontal distance from an interface between the LDD layer 104 and the semiconductor substrate 101 to an interface between the LDD layer 104 and the high concentration impurity diffusion layer 106 is less than or equal to 0.1 µm and a vertical distance from the interface between the LDD layer 104 and the semiconductor substrate 101 to the interface between the LDD layer 104 and the high concentration impurity diffusion layer 106 is also less than or equal to 0.1 *µ* m. Therefore, since the depletion layer 109 is easily stretchable to the entire LDD layer 104 and the above-mentioned problem may easily accrue, an improvement in the off-leak characteristics has been demanded.

Consequently, in patent document 1, there has been proposed a semiconductor device in which the side walls 105 are formed so as to have a two-layer structure having a CVD oxide film and a nitride film and the nitride film is disposed on a surface side thereof, thereby preventing the decrease in the film thickness of the side walls 105. However, although the semiconductor device having the above-mentioned structure allows preventing the decrease in the film thickness of the side walls 105, the side wall 105s are required to be formed so as to have a laminated structure, thereby leading to complication in manufacturing processes.

Therefore, objects of the present invention are to provide a semiconductor device, in which off-leak characteristics can be improved and a silicide transistor and a non-silicide transistor can be concurrently formed on the same one substrate, and a method for manufacturing the semiconductor device.

### SOLUTION TO THE PROBLEMS

To achieve the above objects, the present invention is directed to a semiconductor device including a first transistor having silicide layers formed thereon and a second transistor having no silicide layer formed thereon. In the semiconductor device, each of the first transistor and the second transistor comprises: a gate electrode formed on a gate insulating film on a principal surface of a semiconductor substrate; side walls formed on both lateral walls of the gate electrode; and a source diffusion layer and a drain diffusion layer which are formed in the principal surface of the semiconductor substrate. And in the first transistor, a thickness of each of the side walls is thinner than a thickness of each of the side walls of the second transistor, and each of the source diffusion layer and the drain diffusion layer has a low concentration impurity diffusion layer and a high concentration impurity diffusion layer, which is formed inside of the low concentration impurity diffusion layer, having an impurity concentration higher than an impurity concentration of the low concentration impurity diffusion layer. And a surface of the high concentration impurity diffusion layer and a bottom portion of each of the side walls are at positions of overlapping with each other when viewed from a principal surface direction of the semiconductor substrate, and the silicide layer is formed only in the high concentration impurity diffusion layer.

Through having the above-mentioned structure, in the first transistor, a depletion layer formed at an interface between the semiconductor substrate and the low concentration impurity diffusion layer does not contact the silicide layer, thereby suppressing generation of a leakage current and improving off-leak characteristics.

In addition, the source diffusion layer and the drain diffusion layer in the second transistor may be formed only by the low concentration impurity diffusion layer, or by the low concentration impurity diffusion layer and the high concentration impurity diffusion layer.

In addition, the present invention is directed to a method for manufacturing a semiconductor device including a first transistor having silicide layers formed thereon and a second transistor having no silicide layer formed thereon. In the manufacturing method, a gate electrode of each of the first transistor and the second transistor is first formed on a gate insulating filmon a principal surface of a semiconductor substrate. Next, low concentration impurity diffusion layers of each of the first transistor and the second transistor are formed in the principal surface of the semiconductor substrate by using the gate electrode as a mask. Next, side walls of each of the first transistor and the second transistor are formed on lateral walls of the gate electrode. Next, an insulating film covering an entire surface of the semiconductor substrate is formed. Next, the insulating film is subjected to selective etching processing which is performed so that the insulating film covering the first transistor is removed and the insulating film covering the first transistor remains. Next, in the first transistor, high concentration impurity diffusion layers, each of which has an impurity concentration higher than an impurity concentration of each of the low concentration impurity diffusion layers, are formed inside of the low concentration impurity diffusion layers by using the gate electrode and the side walls as a mask. Next, a metal film covering the first transistor and the second transistor is formed on the principal surface of the semiconductor substrate and silicide is formed by reacting the metal film with the semiconductor substrate. And silicide layers having the silicide formed only in the high concentration impurity diffusion layers of the first transistor are formed by selectively removing an unreacted metal film.

According to the above-mentioned manufacturing method, since in the first transistor, the high concentration impurity diffusion layers are formed by using as the mask the side walls having been subjected to the etching processing, the silicide layer can be formed so that the surface of the high concentration impurity diffusion layer and the bottom portion of the side walls are at positions of overlapping with each other when viewed from the principal surface direction of the semiconductor substrate. Since the silicide layer can be formed only in the high concentration impurity diffusion layer, contacting of the silicide layer and the depletion layer can be avoided, thereby improving the off-leak characteristics.

The manufacturing method may further comprise a step of forming, prior to the step of forming the insulating film, the high concentration impurity diffusion layers, each of which has an impurity concentration higher than an impurity concentration of each of the low concentration impurity diffusion layers, inside of the low concentration impurity diffusion layers by using as the mask the gate electrode and the side walls in the second transistor. The etching processing to which the insulating film is subjected is wet etching. It is preferable that the metal film is one selected from the group consisting of titanium, cobalt, and nickel.

### EFFECT OF THE INVENTION

As described above, in the semiconductor device of the present invention, since the silicide layer is formed only in the high concentration impurity diffusion layer serving as the source diffusion layer and the drain diffusion layer, even if a depletion layer is formed at an interface between the semiconductor substrate and the source and drain diffusion layers, contacting of the depletion layer and the silicide layer can be avoided, thereby improving the off-leak characteristics. In addition, in the method of manufacturing the semiconductor device of the present invention, the silicide layer is formed only in the high concentration impurity diffusion layer as mentioned above, whereby the silicide transistor having the off-leak characteristics improved and the non-silicide transistor can be concurrently formed on the same one substrate.

### BRIEF DESCRIPTION OF THE DRAWINGS

[FIG. 1] FIGs. 1A to 1C are diagrams illustrating a sectional view and an enlarged schematic view of a principal part of a structure of a semiconductor integrated circuit according to a first embodiment of the present invention, and a sectional view illustrating a state of a depletion layer thereof.
[FIG. 2] FIGs. 2A to 2G are diagrams explaining processes of manufacturing the semiconductor integrated circuit according to the first embodiment.
[FIG. 3] FIG. 3 is a diagram illustrating a structure of a semiconductor integrated circuit according to a second embodiment of the present invention.
[FIG. 4] FIGS. 4A to 4G are diagrams explaining a method of manufacturing the semiconductor integrated circuit according to the second embodiment.
[FIG. 5] FIG. 5 is a diagram illustrating a sectional view of a structure of a semiconductor integrated circuit according to a third embodiment of the present invention.
[FIG. 6] FIGs 6A to 6G are diagrams explaining a method of manufacturing the semiconductor integrated circuit according to the third embodiment.
[FIG. 7] FIG. 7 is a diagram illustrating a sectional view of a structure of a conventional semiconductor integrated circuit.
[FIG. 8] FIGs. 8A to 8G are diagrams explaining a method of manufacturing the conventional semiconductor integrated circuit.
[FIG. 9] FIG. 9 is a diagram illustrating a sectional view of a depletion layer of the conventional semiconductor integrated circuit.

### DESCRIPTION OF THE REFERENCE CHARACTERS

- 101: semiconductor substrate
- 102: gate electrode
- 103: gate oxide film
- 104: LDD layer
- 105: side wall
- 106: high concentration impurity diffusion layer
- 107: refractory metal
- 108: silicide layer
- 109: depletion layer
- 111: CVD oxide film

### BEST MODE FOR CARRYING OUT THE INVENTION

### (First Embodiment)

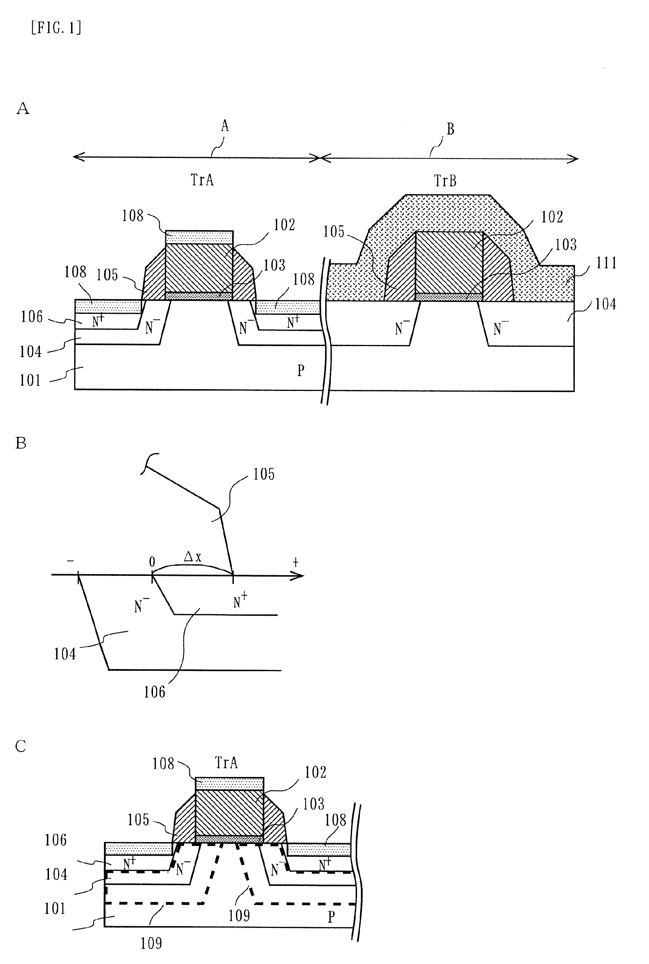

Hereinunder, a semiconductor device according to a first embodiment of the present invention will be described. FIG. 1A is a diagram illustrating a sectional view of a structure of the semiconductor device according to the present embodiment. In FIG. 1A, the semiconductor device comprises an integrated circuit including a silicide MOS transistor TrA and a non-silicide MOS transistor TrB on the same one substrate and has formed therein a silicide region A including a silicide layer and a non-silicide region B including no silicide layer. In FIG. 1A, the semiconductor device comprises a semiconductor substrate 101, gate electrodes 102, gate oxide films 103, LDD layers 104, side walls 105, high concentration impurity diffusion layers 106, silicide layers 108, and a CVD oxide film 111.

The semiconductor substrate 101 is a silicon substrate having formed therein a P type semiconductor. The gate electrode 102 is made of polycrystalline silicon and formed on a principal surface of the semiconductor substrate 101. The gate oxide film 103 is formed on the principal surface of the semiconductor substrate 101 and insulates the gate electrode 102 from the semiconductor substrate 101. The LDD layer 104 is an N⁻ type diffusion layer which is formed by introducing N type impurity, the conductivity type of which is opposite to the conductivity type of the semiconductor substrate 101, on the principal surface of the semiconductor substrate 101 through employing an ion implantation method or the like. The high concentration impurity diffusion layer 106 is an N⁺ type diffusion layer which is formed by introducing N type impurity inside of the LDD layer 104 so as to have an impurity concentration higher than that of the LDD layer 104 through employing the ion implantation method or the like. The side walls 105 are insulating films which are formed on lateral walls of the gate electrode 102. The silicide layer 108 is formed by silicide which is formed by reacting a silicon material with a refractory metal. The CVD oxide film 111 is used for forming the non-silicide region B and prevents formation of the silicide.

Here, the silicide MOS transistor TrA, which is a feature of the semiconductor device according to the present embodiment, will be described. In the silicide MOS transistor TrA, a surface of the high concentration impurity diffusion layer 106 and a bottom portion of the side wall 105 are at positions of overlapping with each other when viewed from a direction of the principal surface of the semiconductor substrate 101. This point will be described indetails. FIG. 1B is a schematic diagram illustrating a principal part of the silicide MOS transistor TrA in a typical manner. In FIG. 1B, on a straight line indicated by an arrow, 0 shows a junction position of the high concentration impurity diffusion layer 106 and the LDD layer 104, an arrow direction shows a plus (+), a direction opposite thereto shows a minus (-). The semiconductor device according to the present invention has an overlap Δx between the surface of the high concentration impurity diffusion layer 106 and the bottom portion of the side wall 105 when viewed from the principal surface direction of the semiconductor substrate 101, satisfying an expression " Δx>0 ".

In the silicide MOS transistor TrA in the conventional semiconductor device shown in FIG. 9, the bottom portion of the side wall 105 is at a position of overlapping the LDD layer 104, not the surface of the high concentration impurity diffusion layer 106 when viewed from the principal surface direction of the semiconductor substrate 101. And an overlap Δx between the bottom portion of the side wall 105 and the high concentration impurity diffusion layer 106 when viewed from the principal surface direction of the semiconductor substrate 101 satisfies an expression "Δx<0".

In the semiconductor device according to the present invention, the silicide layer 108 in source and drain diffusion layers of the silicide MOS transistor TrA is formed only in the high concentration impurity diffusion layer 106. The silicide layer 108 having formed in such a manner can be realized by employing the below-described manufacturing method according to the present invention.

In the semiconductor device according to the present invention, the non-silicide MOS transistor TrB is used in, for example, an input/output section protection circuit which is susceptible to a surge or the like in a semiconductor integrated circuit. The non-silicide MOS transistor TrB is used also for a purpose of protecting a main circuit formed inside of a semiconductor substrate, in order for the transistors not to be damaged even in a case where a high current exceeding specification is inputted to a semiconductor chip terminal, by distancing from the gate electrode 102 the silicide layer 108 formed in the LDD layer 104 and maintaining high resistance of a portion between the source and drain diffusion layers, i. e. a channel portion under the gate electrode 102 in the silicide MOS transistor TrA.

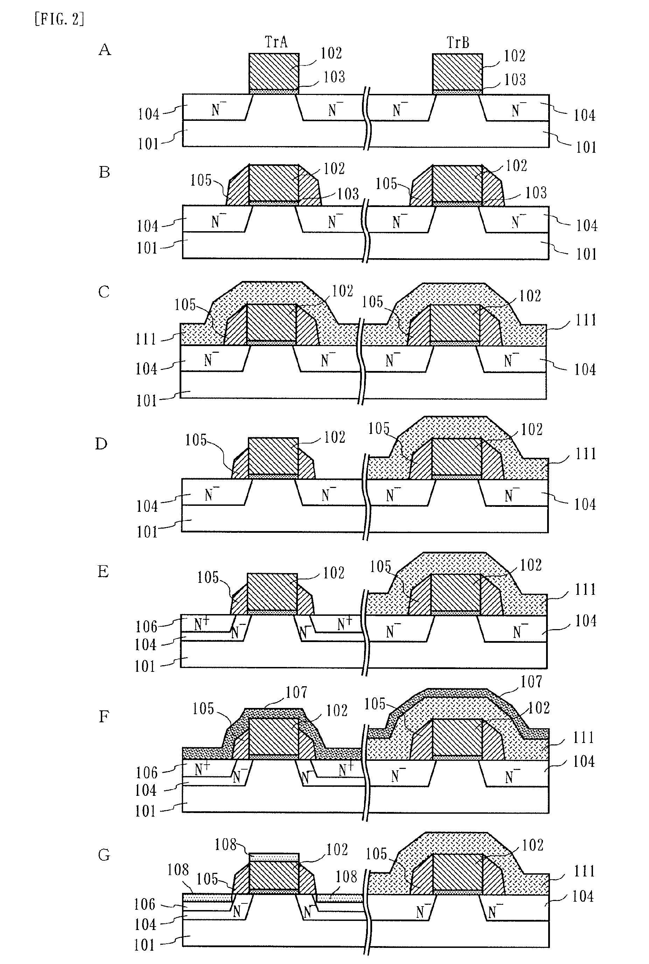

Hereinunder, a method for manufacturing the semiconductor device according to the present embodiment will be described with reference to a specific example. FIG. 2 is a diagram illustrating sectional views of a substrate in respective processes of manufacturing the semiconductor device shown in FIG. 1. FIG. 2A is a diagram illustrating an in-process state in which the silicide MOS transistor TrA and the non-silicide MOS transistor TrB are to be formed on the principal surface of the semiconductor substrate 101. In order to obtain the semiconductor device in this in-process state, the gate oxide film 103 is first formed by depositing a silicon oxide film having a thickness of 90 Å on the principal surface of the semiconductor substrate 101. Next, a polysilicon film is deposited on the gate oxide film 103 so as to have a thickness of 2000Å. Next, a gate electrode 102 which is patterned in a desired manner is formed by subjecting the gate oxide film 103 and the polysilicon film to selective etching processing. Through employing a self-aligning method utilizing the obtained gate electrode 102, the source and drain diffusion layers are formed on the principal surface of the semiconductor substrate 101. Specifically, N type impurity such as phosphorus is ion-implanted toward the principal surface of the semiconductor substrate 101 so as not to apply a high electric field to a channel region under the gate electrode 102. Thus, the LDD layer 104, the impurity concentration of which is 5E17 cm⁻³, serving as the source and drain diffusion layers is formed.

FIG. 2B is a diagram illustrating a state where the side walls 105 are formed on the lateral walls of the gate electrode 102. In order to obtain the side walls 105 in this state, a CVD oxide film (not shown) having a thickness of 1500Å is deposited on an entire surface of the semiconductor substrate 101 in a state shown in FIG. 2A. Through reactive ion etching, the CVD oxide film is etch-backed until a surface of the semiconductor substrate 101 is exposed. Thus, the side walls 105 are formed in a self-aligning manner on the lateral walls of the gate electrode 102. A thickness of the side wall 105 is approximately 100 nm.

FIG. 2C is a diagram illustrating a state where the CVD oxide film 111 having a thickness of 300Å is formed on the entire surface of the semiconductor substrate 101. The CVD oxide film 111 is utilized for selectively forming the silicide region A and the non-silicide region B.

FIG. 2D is a diagram illustrating a state where the CVD oxide film 111 is subjected to selective etching processing. In order to obtain the CVD oxide film 111 in this state, only the CVD oxide film 111 covering the silicide region A is subjected to wet etching processing using HF and the like. Thus, only the CVD oxide film 111 covering the silicide region A is selectively removed and the CVD oxide film 111 covering the non-silicide region B remains as masking for the non-silicide region B. Through the wet etching processing, a thickness of the side wall 105 of the silicide MOS transistor TrA is decreased by an over-etched film thickness. Here, in consideration of an over-etched margin, an etching amount obtained by the wet etching processing is set so that the CVD oxide film 111 can be etched by 500Å. Thus, a film thickness of the side wall 105 of the silicide MOS transistor TrA is decreased by 200Å which is an over-etched thickness, resulting in a film thickness of approximately 80 nm.

FIG. 2E is a diagram illustrating a state where the high concentration impurity diffusion layer 106 is formed inside of the LDD layer 104 of the silicide MOS transistor TrA. The high concentration impurity diffusion layer 106 is formed by employing a self-aligning method utilizing the side walls 105, each of which has the film thickness decreased in the above-mentioned process in FIG. 2E. Specifically, using the gate electrode 102 and the side walls 105 as a mask, an ion implantation with a dose, which is lower than a conventional dose used for the source and drain diffusion layers, of N type impurity such as arsenic is carried out to the semiconductor substrate 101, whereby the high concentration impurity diffusion layer 106 is obtained. An impurity concentration in the high concentration impurity diffusion layer 106 is 1E19 cm⁻³.

FIG. 2F is a diagram illustrating a state where the refractory metal film 107 is formed in the entire surface of the semiconductor substrate 101. The refractory metal film 107 can be obtained by sputtering Co, which is a refractory metal, on the entire surface of the semiconductor substrate 101 so as to have a thickness of 200Å.

FIG. 2G is a diagram illustrating a state where the silicide MOS transistor TrA and the non-silicide MOS transistor TrB are formed on the principal surface of the semiconductor substrate 101. In order to obtain the semiconductor substrate 101 in this state, the refractory metal film 107 is first subjected to first heat treatment at 500 degrees C for 60 seconds. Thus, the principal surface of the semiconductor substrate 101 and the gate electrode 102, which are not covered by the CVD oxide film 111, react with the refractory metal film 107, thereby forming Co silicide. On the other hand, in the non-silicide region B which is covered by the CVD oxide film 111, the Co silicide is not formed. Next, the refractory metal film 107 which has not reacted in the first heat treatment is selectively removed through the wet etching. And second heat treatment at 800 degrees C for 10 seconds is performed. Thus, only in the inside of the high concentration impurity diffusion layer 106 and on the surface of the gate electrode 102 in the silicide MOS transistor TrA, the silicide layer 108 made of the Co silicide is formed in a self-aligning manner. The non-silicide MOS transistor TrB, in which the refractory metal film 107 covering the surface thereof is removed, is covered by the CVD oxide film 111 . The integrated circuit having the silicide MOS transistor TrA and the non-silicide MOS transistor TrB which are concurrently formed on the same one substrate can be obtained and at the same time, the silicide region A including the silicide layer and the non-silicide region B including no silicide layer are formed.

As described above, in the method for manufacturing the semiconductor device according to the present invention, as shown in the process in FIG. 2E, the CVD oxide film 111 for preventing the formation of the silicide is selectively removed and thereafter, the silicide MOS transistor TrA is subjected to ion implantation for forming the high concentration impurity diffusion layer 106. Thus, the high concentration impurity diffusion layer 106 is formed so as to be at a position, when viewed from the principal surface direction of the semiconductor substrate 101, where the surface thereof overlaps the bottom portion of the side wall 105. By forming the silicide layer 108 in a self-aligning manner on the surface of the semiconductor substrate 101 in this state, the silicide layer 108 is formed so as not to protrude to the LDD layer 104 and to be within the region of the high concentration impurity diffusion layer 106.

In the semiconductor device having the above-described structure, when 3.3V is applied to the drain diffusion layer in the silicide MOS transistor TrA and 0V is applied to the gate electrode 102, the source region, and the semiconductor substrate 101, the depletion layer 109 is formed in a boundary between the P type semiconductor substrate 101 and the LDD layer 104 and the depletion layer 109 is stretched by applying a reverse bias. FIG. 1C is a diagram illustrating a state where the depletion layer 109 is formed in the silicide MOS transistor TrA. Since the depletion layer 109 shown in FIG. 1C does not contact the silicide layer 108, a leak pass is not generated, thereby allowing an improvement in the off-leak characteristics. In addition, each of the side wall 105 has a single-layer structure, thereby allowing simplification of the manufacturing processes as compared with those in the above-described patent document 1.

In the above-described manufacturing processes, the high concentration impurity diffusion layers 106 are not formed in the non-silicide MOS transistor TrB. However, when the above-mentioned non-silicide MOS transistor TrB is used in a protection circuit, there accrues no problem. When the above-mentioned non-silicide MOS transistor TrB is used in a surge protection circuit, or is used in a newly re-designd circuit where high-speed and high-current operation are not required, there accrues no problem.

### (Second Embodiment)

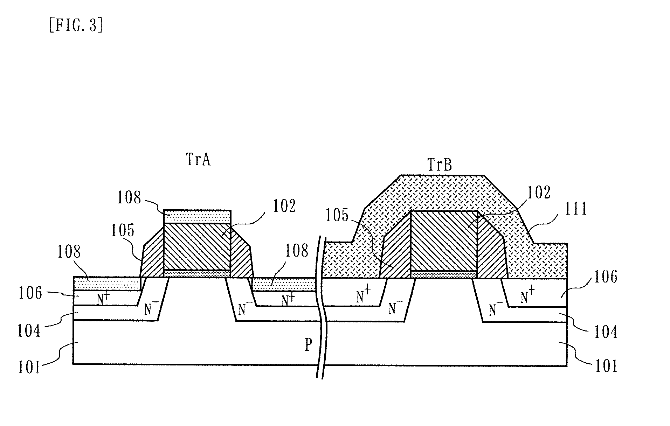

FIG. 3 is a diagram illustrating a sectional view of a structure of a semiconductor device according to a second embodiment of the present invention. Although in the structure of the semiconductor device shown in FIG. 3, the high concentration impurity diffusion layer 106 is formed inside of the LDD layer 104 serving as the source and drain diffusion layers of the non-silicide MOS transistor TrB, the other parts of the structure of the semiconductor device shown in FIG. 3 are the same as those of the above-described semiconductor device according to the first embodiment. When the semiconductor device includes the non-silicide MOS transistor TrB having such a structure, the conventional circuit designing which employs the existing circuit protection technique which cannot be applied for manufacturing the semiconductor device according to the first embodiment can be adopted.

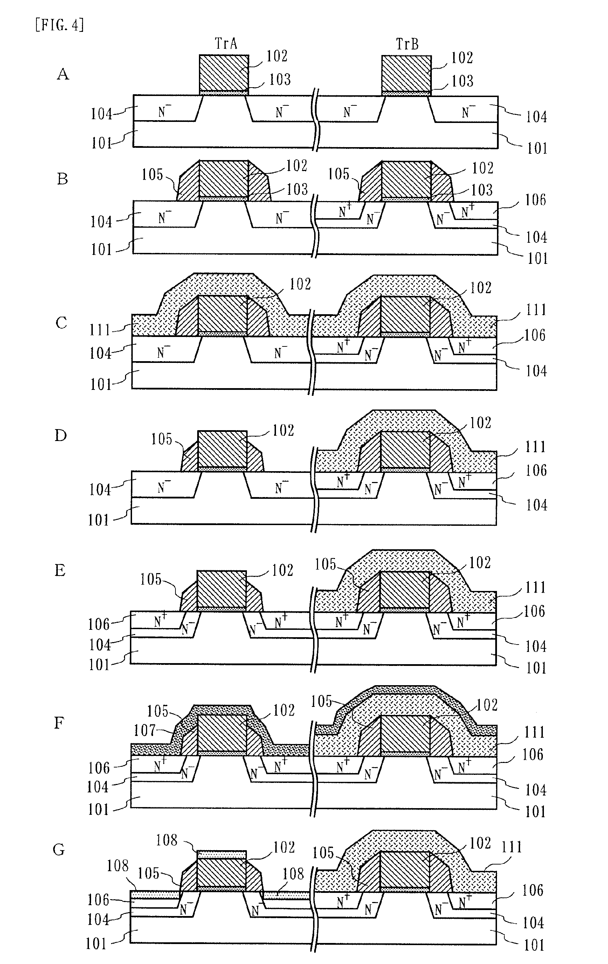

FIG. 4 is a diagram illustrating sectional views of the substrate in respective processes of manufacturing the semiconductor device having the above-mentioned structure. In FIG. 4, since the processes shown in FIG. 4A, and FIG. 4C to FIG. 4G are similar to those shown in FIG. 2A, and FIG. 2C to FIG. 2G, descriptions will be omitted.

FIG. 4B is a diagram illustrating a state where the side walls 105 are formed on lateral walls of the gate electrode 102 and the high concentration impurity diffusion layer 106 is formed in the LDD layer 104 in the non-silicide MOS transistor TrB. In order to obtain the substrate in this state, as in the process shown in FIG. 2B, the side walls 105 are first formed in a self-aligning manner on the lateral walls of the gate electrode 102 of each of the transistors. Next, in the non-silicide MOS transistor TrB, by employing the self-aligning method utilizing the side walls 105, ion implantation with a dose, which is lower than a conventional dose used for the typical source and drain diffusion layers, of N type impurity such as arsenic is carried out to the principal surface of the semiconductor substrate 101, whereby the high concentration impurity diffusion layer 106 having an impurity concentration 1E19 cm⁻³ is formed. Thereupon, the silicide MOS transistor TrA is covered by a mask or the like in order to avoid the ion implantation.

Thereafter, in the processes shown in FIG. 4C to FIG. 4G, by performing the processes similar to those shown in FIG. 2C to FIG. 2G, the semiconductor device according to the present embodiment is obtained.

### (Third Embodiment)

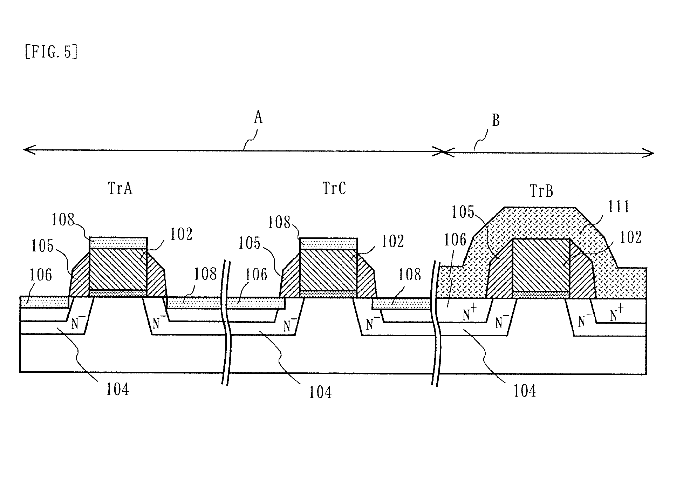

FIG. 5 is a diagram illustrating a sectional view of a semiconductor device according to a third embodiment of the present invention. In FIG. 5, in a silicide region A, a silicide MOS transistor TrA having the same structure as that of each of the first and second embodiments and a silicide MOS transistor TrC having the same structure as that of the conventional semiconductor device are formed, and in a non-silicide region B, a non-silicide transistor TrB having the same structure as that of the second embodiment is formed. The semiconductor device including the above-mentioned transistors can be used in a wider range of application than the semiconductor device according to the second embodiment.

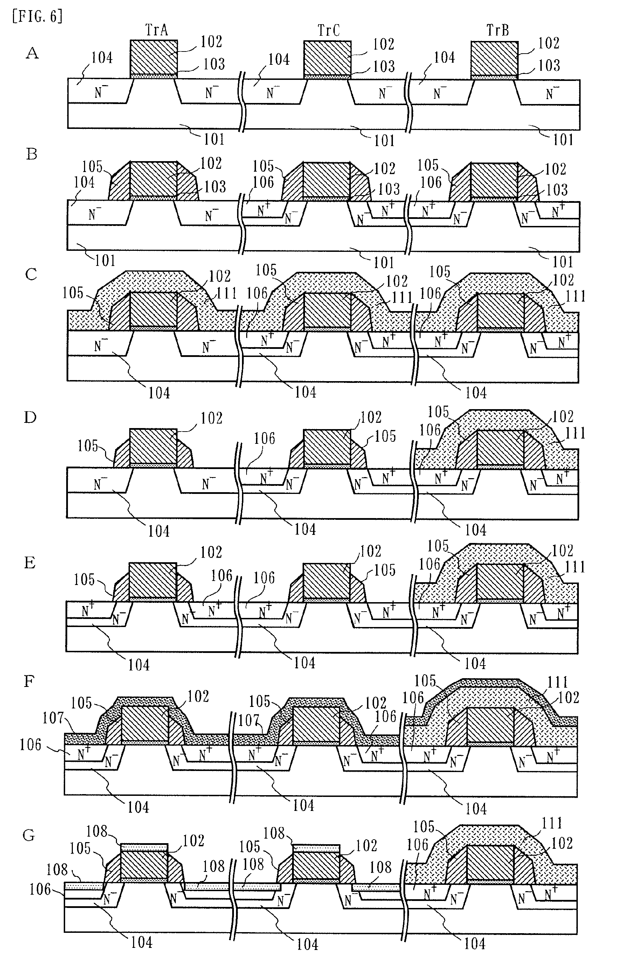

Hereinunder, a method for manufacturing the semiconductor device according to the present embodiment will be described with reference to a specific example. FIG. 6 is a diagram illustrating sectional views of a substrate in respective processes of manufacturing the semiconductor device shown in FIG. 5. FIG. 6A is a diagram illustrating an in-process state in which the silicide MOS transistors TrA and TrC and the non-silicide MOS transistor TrB are to be formed on a principal surface of the semiconductor substrate 101. In order to obtain the semiconductor device in this in-process state shown in FIG. 6A, as in the process described with reference to FIG. 2A, a gate oxide film 102 is formed on a gate oxide film 103 in a region in which each of the transistors is formed. Through employing a self-aligning method utilizing the obtained gate electrode 102, an LDD layer 104 serving as a source and drain diffusion layers is formed on the principal surface of the semiconductor substrate 101.

FIG. 6B is a diagram illustrating a state where side walls 105 are formed on lateral walls of the gate electrode 102 and a high concentration impurity diffusion layer 106 is formed in the LDD layer 104 in each of the silicide MOS transistor TrC and the non-silicide MOS transistor TrB. In order to obtain the substrate in this state, as in the process shown in FIG. 2B, side walls 105 are formed in a self-aligning manner on lateral walls of the gate electrode 102 in each of the respective transistors. Next, in the LDD layer 104 of each of the silicide MOS transistor TrC and the non-silicide MOS transistor TrB, by employing the self-aligningmethodutilizing the side walls 105, ion implantation with a dose, which is lower than a conventional dose used for the typical source and drain diffusion layers, of N type impurity is carried out to the principal surface of the semiconductor substrate 101, whereby the high concentration impurity diffusion layer 106 having an impurity concentration 1E19 cm⁻³ is formed. Thereupon, the silicide MOS transistor TrA is covered by a mask or the like in order to avoid the ion implantation.

FIG. 6C is a diagram illustrating a state where an entire surface of the substrate is covered by a CVD oxide film 111. The CVD oxide film 111 is formed by the procedure described with reference to FIG. 2C. FIG. 6D is a diagram illustrating a state where the CVD oxide film 111 is subjected to selective etching processing. Although the etching processing for the CVD oxide film 111 is the same as that described with reference to FIG. 2D, in the present embodiment, only the CVD oxide film 111 covering the silicide region A, which is the CVD oxide film 111 covering the silicide MOS transistors TrA and TrC, is subjected to wet etching processing using HF and the like. Thus, the silicide MOS transistors TrA and TrC are exposed and the non-silicidetransistor TrB remains being covered by the CVD oxide film 111. A thickness of the side wall 105 of each of the silicide MOS transistors TrA and TrC is decreased by an over-etched film thickness.

FIG. 6E is a diagram illustrating a state where the high concentration impurity diffusion layer 106 is formed inside of the LDD layer 104 in the silicide MOS transistor TrA. As in the process shown in FIG. 2F, the high concentration impurity diffusion layer 106 is formed by employing a self-aligning method utilizing the side walls 105 of which film thickness has been decreased.

FIG. 6F is a diagram illustrating a state where the refractory metal film 107 is formed in the entire surface of the semiconductor substrate 101. The refractory metal film 107 is formed by the same process as that shown in FIG. 2F.

FIG. 6G is a diagram illustrating a state where the silicide MOS transistors TrA and TrC and the non-silicide MOS transistor TrB are formed on the principal surface of the semiconductor substrate 101. The semiconductor substrate 101 in this state is formed by the same process as that shown in FIG. 2G. Thus, the respective kinds of transistors, which are the silicide MOS transistors TrA and TrC and the non-silicide MOS transistor TrB, can be concurrently formed on the same one substrate.

As described above, the method for manufacturing the semiconductor device according to the present embodiment allows an improvement in off-leak characteristics of only a desired transistor among a plurality of transistors included in the semiconductor device.

Although in the above-described embodiments, the MOS transistor in which the silicide layer 108 is formed on the gate electrode 102 is described as an example, the present invention is not limited thereto and no silicide may be formed on the surface of the gate electrode 102. Although in the above-described embodiments, an example in which the silicide for forming the silicide layer 108 is the Co silicide is described, the silicide layer may be formed by Ti silicide, Ni silicide or the like. In the embodiments,thethicknesses,the materials,theheattreatment conditions and the like of the gate electrode 102, the side walls 105, the CVD oxide film 111, and the like are described as one example of the present invention, and the present invention is not limited thereto. Furthermore, although in the above-described embodiments, examples of the transistors each having the N type impurity layers formed in the P type semiconductor substrate are described, the present invention is applicable to transistors or the like in which P type impurity layers are formed in an N type semiconductor substrate.

### INDUSTRIAL APPLICABILITY

Since a semiconductor device and a method for manufacturing the semiconductor device according to the present invention have a feature that a silicide transistor having fine off-leak characteristics and a non-silicide transistor can be realized on the same one substrate, the present invention is useful for an image sensor, a semiconductor in an in-vehicle product, or the like.

## Claims

1. A semiconductor device including a first transistor having silicide layers formed thereon and a second transistor having no silicide layer formed thereon, wherein
each of the first transistor and the second transistor comprises:
a gate electrode formed on a gate insulating film on a principal surface of a semiconductor substrate;
side walls formed on both lateral walls of the gate electrode; and
a source diffusion layer and a drain diffusion layer which are formed in the principal surface of the semiconductor substrate, and
in the first transistor,
a thickness of each of the side walls is thinner than a thickness of each of the side walls of the second transistor,
each of the source diffusion layer and the drain diffusion layer has a low concentration impurity diffusion layer and a high concentration impurity diffusion layer, which is formed inside of the low concentration impurity diffusion layer, having an impurity concentration higher than an impurity concentration of the low concentration impurity diffusion layer,
a surface of the high concentration impurity diffusion layer and a bottom portion of each of the side walls are at positions of overlapping with each other when viewed from a principal surface direction of the semiconductor substrate, and
the silicide layer is formed only in the high concentration impurity diffusion layer.

2. The semiconductor device according to claim 1, wherein the source diffusion layer and the drain diffusion layer in the second transistor are formed only by the low concentration impurity diffusion layer.

3. The semiconductor device according to claim 1, wherein the source diffusion layer and the drain diffusion layer in the second transistor are formed by the low concentration impurity diffusion layer and the high concentration impurity diffusion layer.

4. A method for manufacturing a semiconductor device including a first transistor having silicide layers formed thereon and a second transistor having no silicide layer formed thereon, the method comprising the steps of:
forming a gate electrode of each of the first transistor and the second transistor on a gate insulating film on a principal surface of a semiconductor substrate;
forming low concentration impurity diffusion layers of each of the first transistor and the second transistor in the principal surface of the semiconductor substrate by using the gate electrode as a mask;
forming side walls of each of the first transistor and the second transistor on lateral walls of the gate electrode;
forming an insulating film covering an entire surface of the semiconductor substrate;
subjecting the insulating film to selective etching processing which is performed so that the insulating film covering the first transistor is removed and the insulating film covering the first transistor remains;
forming, in the first transistor, high concentration impurity diffusion layers, each of which has an impurity concentration higher than an impurity concentration of each of the low concentration impurity diffusion layers, inside of the low concentration impurity diffusion layers by using the gate electrode and the side walls as a mask;
forming a metal film covering the first transistor and the second transistor on the principal surface of the semiconductor substrate and forming silicide by reacting the metal film with the semiconductor substrate; and
forming silicide layers having the silicide formed only in the high concentration impurity diffusion layers of the first transistor by selectively removing an unreacted metal film.

5. The method for manufacturing the semiconductor device according to claim 4, further comprising a step of forming, prior to the step of forming the insulating film, high concentration impurity diffusion layers, each of which has an impurity concentration higher than an impurity concentration of each of the low concentration impurity diffusion layers, inside of the low concentration impurity diffusion layers by using as a mask the gate electrode and the side walls in the second transistor.

6. The method for manufacturing the semiconductor device according to claim 4, wherein the etching processing to which the insulating film is subjected is wet etching.

7. The method for manufacturing the semiconductor device according to claim 4, wherein the metal film is one selected from the group consisting of titanium, cobalt, and nickel.
